# EUROPEAN PATENT APPLICATION

(11) **EP 4 585 452 A1**
(43) Date of publication of application: **16.07.2025**
(21) Application number: 24218281.4
(22) Date of filing: 09.12.2024
(51) Int. Cl.: B60L 53/65, B60L 53/80

(54) **VEHICLE AND METHOD FOR DETERMINING CHARACTERISTICS OF BATTERY**

(30) Priority: 09.01.2024 JP 2024001347
(71) Applicant: TOYOTA JIDOSHA KABUSHIKI KAISHA, Aichi-ken, 471-8571 (JP)
(72) Inventor: ICHIKAWA, Shinji, Toyota-shi, 471-8571 (JP)
(74) Representative: TBK

(57) **Abstract**

An ECU executes processing including a step S100 of acquiring, from a battery pack before replacement, an amount of time t(1) necessary for charging of a predetermined state of charge of the battery pack before replacement, a step S102 of acquiring, from a battery pack after replacement, an amount of time t(2) necessary for charging of the predetermined state of charge of the battery pack, a step S106 of setting a determination flag to an on state when determination is made that a magnitude of difference between the time t(1) and the time t(2) is no less than a threshold value α, and a step S108 of setting the determination flag to an off state when determination is made that the magnitude of the difference is smaller than the threshold value α.

## Description

### BACKGROUND OF THE INVENTION

### 1. Field of the Invention

The present disclosure relates to a vehicle equipped with a detachably attachable battery and a method for determining characteristics of the battery.

### 2. Description of Related Art

Japanese Unexamined Patent Application Publication No. 2011-091879 (JP 2011-091879 A) discloses a technology for displaying a remaining charge time required to fully charge a battery based on terminal voltage, battery temperature, and full charge voltage information of the battery.

### SUMMARY OF THE INVENTION

Now, in a vehicle in which a detachably attachable battery is installed, when the battery is replaced, a user may feel uncomfortable due to difference in performance of the replaced battery as to that of a reference battery of specifications set in advance. For example, when the reference battery is replaced with a battery with a lower input/output, there are cases in which the user feels uncomfortable due to change in output performance and the increased charging time before and after the replacement.

The present disclosure can suppress such a sense of uncomfortableness from being imparted to the user before and after battery replacement.

A vehicle according to a first aspect of the invention includes an acquisition device that acquires battery information from a battery installed as a power supply in the vehicle, a notification device that performs notification of vehicle information regarding the vehicle, and a control device that controls the notification device. After a first battery installed in the vehicle is replaced with a second battery, when a difference in characteristics is found between the second battery, and a reference battery of specifications set in advance, based on the battery information acquired from the second battery, the control device performs notification of information indicating that there is the difference in the characteristics before and after replacement, using the notification device.

In this way, when replacing the first battery with the second battery, and when there is the difference in the characteristics between the second battery and a reference battery of specifications set in advance, the user will be notified of the difference in the characteristics, and accordingly the user can recognize that there is the difference in the characteristics before and after replacement. Accordingly, imparting uncomfortable sensations to the user due to difference in performance before and after replacement of the battery can be suppressed.

In the vehicle according to the above aspect, after the second battery being connected to the vehicle as the power supply, when a magnitude in difference between a value indicating a characteristic of the reference battery that is set in advance and a value indicating the characteristic of the second battery that is set in advance is greater than a threshold value, the control device may perform notification of information indicating that there is the difference in the characteristics, using the notification device.

In this way, after being connected to the vehicle as a power supply, when the magnitude of the difference in the characteristics is greater than the threshold value, the notification device will be used to notify the user of the difference in characteristics, and accordingly the user can recognize that there is a difference in characteristics before and after the replacement. Accordingly, imparting uncomfortable sensations to the user due to difference in performance before and after replacement of the battery can be suppressed.

In the vehicle according to the above aspect, the notification device may be a display device. When the vehicle is started for the first time after the battery being replaced with the second battery, and the magnitude of the difference is greater than the threshold value, the control device may use the notification device to cause the display device to display an image including information indicating that there is the difference in the characteristics.

In this way, the image including information indicating that there is the difference in the characteristics is displayed on the display device, and accordingly the user can recognize that there is the difference in the characteristics before and after replacement. Accordingly, imparting uncomfortable sensations to the user due to difference in performance before and after replacement can be suppressed.

In the vehicle according to the above aspect, when a magnitude in difference between a first amount of time necessary to change a State of Charge (SOC) of the reference battery by a value set in advance and a second amount of time necessary to change the SOC of the second battery by the value set in advance is greater than a threshold value, the control device may perform notification of information indicating that there is the difference in the characteristics, using the notification device.

In this way, when the magnitude of difference between the first amount of time and the second amount of time is greater than the threshold value, the user is notified that there is the difference in the characteristics, and accordingly the user can recognize that there is the difference in the characteristics before and after replacement. Accordingly, imparting uncomfortable sensations to the user due to difference in performance before and after replacement of the battery can be suppressed.

In the vehicle according to the above aspect, when a magnitude in difference between a first voltage of the reference battery and a second voltage of the second battery is greater than a threshold value, in a state in which the reference battery and the second battery are at the same SOC, the control device may perform notification of information indicating that there is the difference in the characteristics, using the notification device.

In this way, when the magnitude of difference between the first voltage and the second voltage is greater than the threshold value, the user is notified that there is the difference in the characteristics, and accordingly the user can recognize that there is the difference in the characteristics before and after replacement. Accordingly, imparting uncomfortable sensations to the user due to difference in performance before and after replacement of the battery can be suppressed.

In the vehicle according to the above aspect, when a supplier of the reference battery and a supplier of the second battery are different, the control device may perform notification of information indicating that there is the difference in the characteristics, using the notification device.

In this way, when the supplier of the reference battery and the supplier of the second battery are different, the user is notified of the difference in the characteristics, and accordingly can recognize that there is the difference in the characteristics before and after replacement. Accordingly, imparting uncomfortable sensations to the user due to difference in performance before and after replacement of the battery can be suppressed.

In the vehicle according to the above aspect, the specifications set in advance may include specifications of the first battery.
In this way, when the specifications of the second battery differ from the specifications of the first battery, the user is notified of the difference in the characteristics, and accordingly can recognize that there is the difference in the characteristics before and after replacement. Accordingly, imparting uncomfortable sensations to the user due to difference in performance before and after replacement of the battery can be suppressed.

In the vehicle according to the above aspect, the reference battery may include the first battery before replacement. When an installation position of the first battery and an installation position of the second battery differ, the control device may perform notification of information indicating that there is the difference in the characteristics, using the notification device.

In this way, when the installation position of the first battery and the installation position of the second battery are different, the user is notified that there is the difference in the characteristics, and accordingly can recognize that there is the difference in the characteristics before and after replacement. Accordingly, imparting uncomfortable sensations to the user due to difference in performance before and after replacement of the battery can be suppressed.

A method, for determining characteristics of a battery to be installed in a vehicle as a power supply, according to a second aspect of the invention, includes acquiring battery information from a second battery after a first battery is replaced with the second battery, and when a difference in characteristics is found between the second battery and a reference battery of specifications set in advance based on the battery information of the second battery, providing notification of information indicating that there is the difference in the characteristics before and after replacement.

In the method according to the above aspect, after the second battery is connected to the vehicle as the power supply, when a magnitude in difference between a value indicating a characteristic of the reference battery set in advance and a value indicating the characteristic of the second battery set in advance is greater than a threshold value, notification of information indicating that there is the difference in the characteristics may be provided.

A vehicle according to a third aspect of the invention includes a notification device that performs notification of vehicle information regarding the vehicle, and a control device that controls the notification device. The control device is configured to acquire battery information from a battery installed as a power supply in the vehicle, and perform, after a first battery installed in the vehicle is replaced with a second battery, when a difference in characteristics is found between the second battery, and a reference battery of specifications set in advance, based on the battery information acquired from the second battery, notification of information indicating that there is the difference in the characteristics before and after replacement, using the notification device.

According to the present disclosure, a vehicle can be provided that can suppress a sense of uncomfortableness from being imparted to the user before and after battery replacement.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram illustrating an example of a configuration of a vehicle according to an embodiment;
FIG. 2 is a diagram illustrating an example of a configuration of a battery replacement system for replacing battery packs;
FIG. 3 is a flowchart showing an example of a replacement method for battery packs;
FIG. 4 is a flowchart showing an example of battery characteristics determination processing in FIG. 3;
FIG. 5 is a diagram illustrating an example of a normal display of energy flow during regenerative braking;
FIG. 6 is a diagram illustrating an example of a display of energy flow during regenerative braking;
FIG. 7 is a diagram illustrating another example of a display of energy flow during regenerative braking;
FIG. 8 is a flowchart showing an example of battery characteristics determination processing in a modification;
FIG. 9 is a flowchart showing another example of battery characteristics determination processing in the modification;
FIG. 10 is a flowchart showing yet another example of battery characteristics determination processing in the modification;
FIG. 11 is a diagram illustrating an example of a configuration of a vehicle according to the modification; and
FIG. 12 is a diagram illustrating another example of a configuration of the vehicle according to the modification.

### DETAILED DESCRIPTION OF EMBODIMENTS

Embodiments of the present disclosure will be described in detail below with reference to the drawings. Note that the same or corresponding parts are denoted by the same signs throughout the drawings, and description thereof will not be repeated.

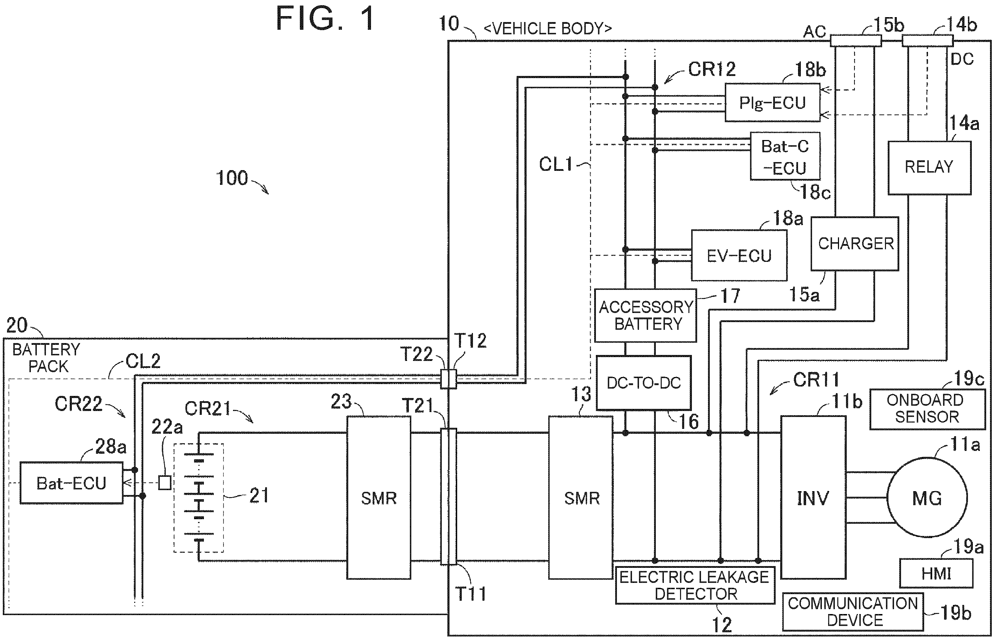

FIG. 1 is a diagram illustrating an example of a configuration of a vehicle according to an embodiment. With reference to FIG. 1, a vehicle 100 is, for example, a passenger car including a vehicle body 10 and a battery pack 20. The vehicle body 10 is part of the vehicle 100 other than the battery pack 20. The vehicle body 10 is equipped with a vehicle drive device that serves as a drive source. The vehicle drive device includes a motor generator (MG) 11a and an inverter 11b. The vehicle drive device is configured to cause the vehicle 100 to travel, using electric power output from the battery pack 20. The battery pack 20 is configured to be connectable to the inverter 11b. The vehicle 100 is, for example, a battery electric vehicle that does not have an internal combustion engine. However, this is not restrictive, and the vehicle 100 may be a plug-in hybrid electric vehicle equipped with an internal combustion engine, or may be another kind of electrified vehicle. The vehicle body 10 may be equipped with an electric leakage detector 12.

The vehicle body 10 includes circuits CR11 and CR12. The battery pack 20 includes circuits CR21 and CR22. The circuit CR12 includes an accessory battery 17. The circuit CR21 includes a battery 21. The battery 21 is a secondary battery such as, for example, a lithium-ion battery, a nickel metal hydride battery, or a sodium-ion battery. The kind of the secondary battery may be a liquid secondary battery or an all-solid-state secondary battery. A plurality of secondary batteries may make up an assembled battery. The accessory battery 17 corresponds to a low-voltage power supply that outputs electric power of which a voltage is lower than voltage of the battery 21. A direct current (DC)-to-DC converter 16 is provided between the circuits CR11 and CR12.

The circuit CR11 in the vehicle body 10 includes the MG 11a, the inverter 11b, a DC charging relay 14a, a DC inlet 14b, an alternating current (AC) charger 15a, and an AC inlet 15b. The circuit CR21 in the battery pack 20 is provided with a battery management system (BMS) 22a.

The vehicle body 10 further includes a terminal T11 to which the battery pack 20 can be detachably attached, and an SMR 13 disposed between the terminal T11 and the vehicle drive device (inverter 1 1b). The circuit CR11 (high-voltage power supply line) is connected to the terminal T11 via the SMR 13. The battery pack 20 includes a terminal T21 that is detachably attachable to the vehicle body 10, and an SMR 23 that is disposed between the terminal T21 and a circuit CR21. The circuit CR21 (high-voltage power supply line) is connected to the terminal T21 via the SMR 23. The term "SMR" stands for "system main relay".

The terminal T21 of the battery pack 20 is connected to the terminal T11 of the vehicle body 10. The SMR 23 of the battery pack 20 is disposed between the terminal T21 and the battery 21 in the battery pack 20.

The vehicle body 10 further includes a terminal T12 to which the battery pack 20 is detachably attachable. The circuit CR12 (low-voltage power supply line) in the vehicle body 10 is connected to the terminal T12. A communication line CL1 (dashed line in FIG. 1) in the vehicle body 10 is also connected to the terminal T12. The battery pack 20 further includes a terminal T22. In the battery pack 20, the circuit CR22 (low-voltage power supply line) and a communication line CL2 (dashed line in FIG. 1) are connected to the terminal T22.

The accessory battery 17 supplies electric power to drive accessories installed in the vehicle 100. The accessory battery 17 outputs direct current electric power to the circuit CR12 (low-voltage power supply line). The circuit CR12 further includes ECUs 18a, 18b, and 18c in addition to the accessory battery 17. The circuit CR22 further includes an ECU 28a. The accessory battery 17 supplies electric power to, for example, each of the ECUs 18a to 18c and 28a that are connected to the low-voltage power supply line. The term "ECU" stands for "electronic control unit".

The ECU 18a corresponds to a control device (EV-ECU) that manages various kinds of control related to the vehicle 100. The ECU 18b corresponds to a control device (Plg-ECU) that detects the states of the DC inlet 14b and the AC inlet 15b. The ECU 18c corresponds to a control device (Bat-C-ECU) that controls the DC charging relay 14a and the AC charger 15a. The ECU 28a corresponds to a control device (Bat-ECU) that monitors a state of the battery 21 and controls the SMR 23.

Each ECU includes a processor and a storage device. The storage device is configured to save stored information. The storage device stores programs and various kinds of information to be used by the programs. In the present embodiment, various kinds of control are executed by the processor executing the programs stored in the storage device. Note however, that this processing may be executed by hardware (electronic circuitry) alone, without using software.

In the vehicle 100, the ECUs are connected so as to be capable of communication with each other via an in-vehicle network (e.g., a Controller Area Network (CAN)). The ECU 18a acquires information from other ECUs, controls the inverter 11b, the DC-to-DC converter 16, and the SMRs 13 and 23, transmits control commands to the ECU 18c and the ECU 28a, and so forth.

The BMS 22a detects the state (current, voltage, temperature, etc.) of the battery 21, and outputs detection results thereof to the ECU 28a. The ECU 18a acquires information indicating the battery state from the ECU 28a.

The DC-to-DC converter 16 transforms direct current electric power between the circuit CR11 and the circuit CR12. Specifically, the DC-to-DC converter 16 steps down the direct current electric power from the battery 21 and performs output thereof to the accessory battery 17 and other accessories connected to the circuit CR12. The capacity of the battery 21 is greater than the capacity of the accessory battery 17.

Terminals T21 and T22 of the battery pack 20 are connected to terminals T11 and T12, whereby the battery pack 20 is attached to the vehicle body 10, making up the vehicle 100. In the vehicle 100, the communication line CL1 of the vehicle body 10 and the communication line CL2 of the battery pack 20 are connected. These communication lines make up the in-vehicle network (e.g., the CAN) of the vehicle 100.

The MG 11a functions as a traction motor. The inverter 11b functions as a power control unit (PCU) for the MG 11a. The inverter 11b drives the MG 11a using electric power supplied from the battery 21 of each of the battery packs. The MG 11a converts the electric power into torque to rotate drive wheels of the vehicle 100. The MG 11a also performs regenerative power generation, for example, when the vehicle 100 decelerates, and charges the battery 21.

Each of the DC inlet 14b and the AC inlet 15b has a terminal for detecting connection/disconnection of a charging cable (plug) of an external power supply (omitted from illustration), and outputs a signal, indicating whether the charging cable is connected, to the ECU 18b. The ECU 18a acquires information indicating the inlet state from the ECU 18b, and transmits a control command to the ECU 18c. The AC charger 15a performs AC-to-DC conversion. The ECUs 18a to 18c cooperate to execute plug-in charging of the battery 21.

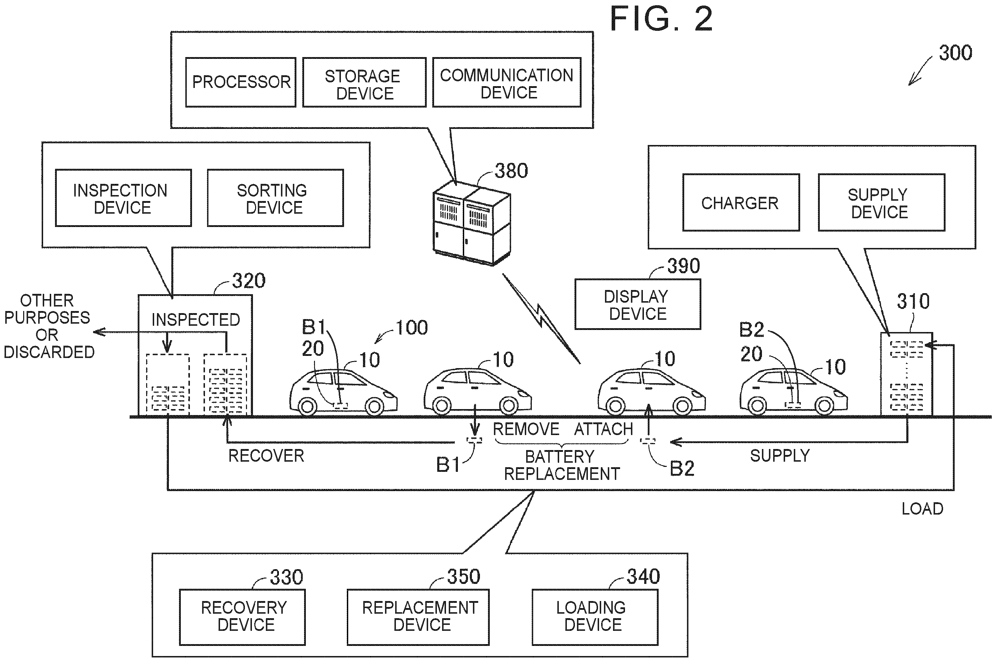

The vehicle body 10 further includes a human-machine interface (HMI) 19a and a communication device 19b. Note that the HMI 19a and the communication device 19b also receive supply of electric power from the accessory battery 17. The HMI 19a includes an input device and a display device provided in a vehicle cabin. The HMI 19a may include a touchscreen display. The input device outputs signals in accordance with input from a user to the ECU 18a. The communication device 19b is configured to be capable of wireless communication with a server 380 (FIG. 2), which will be described later. Various kinds of sensors that are omitted from illustration (representatively referred to as "onboard sensor 19c") are also installed in the vehicle body 10. The ECU 18a is configured to acquire detection results from these sensors, either directly or via other ECUs.

In the present embodiment, the HMI 19a includes a start switch. The start switch is commonly referred to as a "power switch", an "ignition switch", or the like. The user of the vehicle 100 can operate the start switch to start or stop the control system of the vehicle 100 (including the ECUs), and to place the vehicle 100 in a Ready-ON state or a Ready-OFF state. The operations may be remote operations (e.g., request by wireless communication).

The Ready-ON state is a state in which the voltage of the battery 21 of the battery pack 20 connected to the vehicle body 10 is applied to the circuit CR11 of the vehicle body 10. In the Ready-ON state, the SMR 13 is in a closed state, the SMR 23 of the battery pack 20 is also in a closed state, and electric power is supplied from the battery 21 connected to the SMR 23 in a closed state to the vehicle drive device (MG 11a and inverter 11b). The Ready-OFF state is a state in which the voltage of the battery 21 is not applied to the circuit CR11. In the Ready-OFF state, the SMR 13 is in an open state, and electric power is not supplied from the battery 21 of the battery pack 20 to the vehicle drive device.

The battery pack 20 installed in the vehicle 100 can be replaced with another battery pack. FIG. 2 is a diagram illustrating an example of a configuration of a battery replacement system for replacing battery packs. A battery replacement system 300 illustrated in FIG. 2 is implemented in a battery replacement station, for example.

Referring to FIG. 2, the battery replacement system 300 is configured to remove a battery pack installed in the vehicle 100 from the vehicle body 10 and attach another battery pack to the vehicle body 10. Furthermore, replacement of the battery pack includes a case in which the battery pack 20 is removed and then another battery pack 20 is installed in one of a plurality of installation positions.

Hereinafter, the battery pack recovered from the vehicle 100 will be referred to as "battery pack B1". Moreover, the battery pack to be attached to the vehicle 100 in place of the battery pack B1 will be referred to as "battery pack B2". Each of the battery packs B1 and B2 has the same configuration as the battery pack 20 illustrated in FIG. 1. The battery pack B2 after being attached to the vehicle body 10 functions as the battery pack 20 (FIG. 1) in the vehicle 100.

Specifically, the battery replacement system 300 includes a first stockpile device 310, a second stockpile device 320, a recovery device 330, a loading device 340, a replacement device 350, the server 380, and a display device 390. The first stockpile device 310 stockpiles a plurality of the battery packs to be supplied to vehicles. The first stockpile device 310 includes a pack accommodation unit (e.g., a storage shed), as well as a charger and a supply device. The second stockpile device 320 stockpiles battery packs recovered from a plurality of vehicles. The second stockpile device 320 includes a pack accommodation unit (e.g., a storage shed), as well as an inspection device and a sorting device. The server 380 includes a processor, a storage device, and a communication device, and functions as a control device. The storage device stores information (e.g., specification information) regarding each battery pack present in the battery replacement system 300, with the information being distinguished by identification information of the battery pack (pack ID). The display device 390 displays information in accordance with instructions from the server 380.

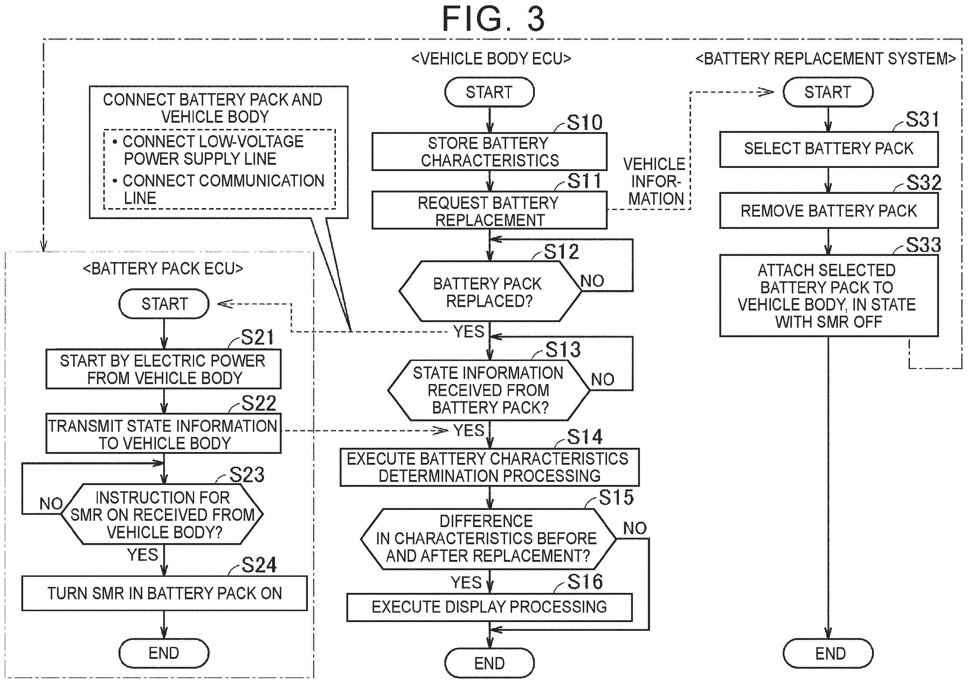

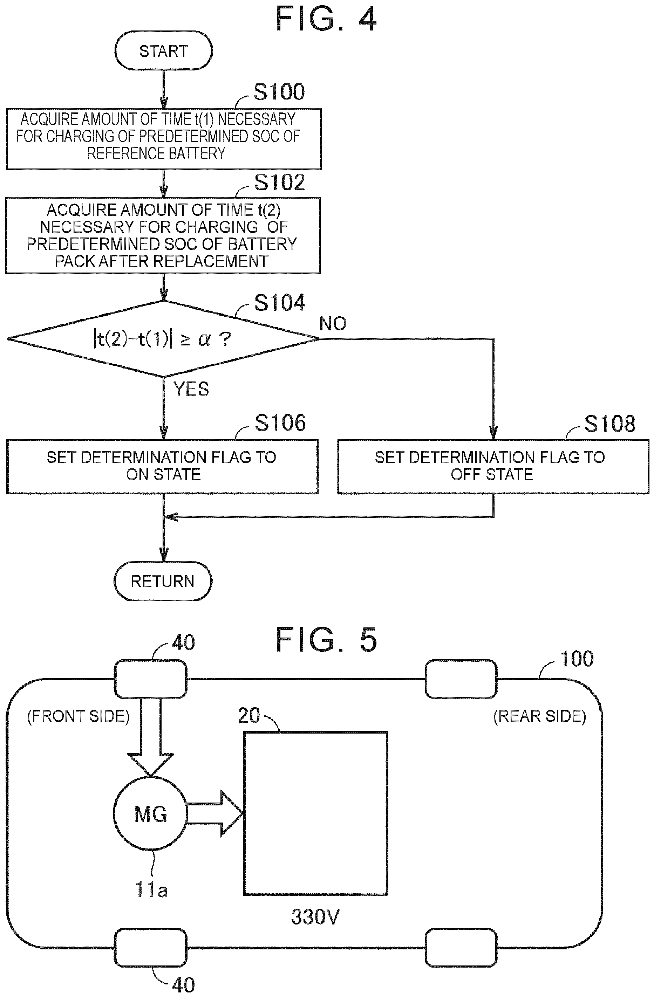

A battery replacement method will be described below with reference to FIGS. 1 to 4. FIG. 3 is a flowchart showing an example of a replacement method of battery packs. FIG. 4 is a flowchart showing an example of battery characteristics determination processing in FIG. 3. For example, following the vehicle 100 being parked in a predetermined area in the battery replacement station, the ECU 18a starts a processing flow of S10 to S14 shown in FIG. 3. The ECU 18a may start the processing flow in response to a request from a terminal of a user of the vehicle 100 (user terminal) or a request from an input device in the vehicle 100. The ECU 18a and the server 380 are configured to be capable of wireless communication with each other. The ECU 18a may be an example of a control device.

In step (hereinafter, "step" will be abbreviated to "S") S10, the ECU 18a acquires information relating to characteristics of the battery pack 20 set in advance. The ECU 18a reads information regarding the specifications of a battery of the battery pack 20 having specifications set in advance (hereinafter referred to as a reference battery) from the memory. The specifications set in advance include, for example, the specifications of the battery pack B1 before replacement. The specifications set in advance include specifications of an initial battery installed in the vehicle 100. The specifications set in advance include, for example, the model of battery pack 20, the kind of battery, the full charge capacity of the battery pack 20, the time required to charge the battery pack 20 and raise the State of Charge (SOC) indicating the charged state by an amount set in advance (hereinafter referred to as "predetermined SOC"), a map indicating a relation between the SOC and the voltage of the battery pack 20, information regarding the supplier of the battery pack 20, and so forth. The SOC is, for example, a proportion of the current charge amount as to the charge amount in a fully charged state, expressed as a percentage ranging from 0 to 100%.

Note that, for example, when information for identifying a battery of specifications set in advance is stored in the memory of ECU 18a, and further the specifications of the battery pack 20 that is installed are found to be the specifications set in advance, using information that the ECU 18a receives from the battery pack 20, the above information may be received from the battery pack 20. The processing then transitions to S11.

In S11, the ECU 18a transmits to the server 380 a signal requesting replacement of the battery pack (hereinafter referred to as "replacement request signal"). The replacement request signal includes identification information (vehicle ID) of the vehicle 100, specification information of the battery pack (battery pack B1) installed in the vehicle 100, and information regarding the installation position of the battery pack. The replacement request signal may include specification information of the vehicle body 10 instead of or in addition to the specification information of the battery pack B1.

In S12, the ECU 18a determines whether replacement of the battery pack has been performed. ECU 18a may determine that the battery pack has been replaced, for example, when receiving a replacement completion signal transmitted from the server 380 when the battery pack replacement is completed. While replacement of the battery pack has not ended (NO in S12), the determination in S12 is repeatedly executed.

Upon receiving the replacement request signal, the server 380 starts the processing flow of S31 to S33 in FIG. 3.

In S31, the server 380 selects a battery pack that meets the specifications of the vehicle 100 (the specifications of the battery pack B1 or the vehicle body 10) indicated by the replacement request signal, from among the battery packs (inventory) held in the first stockpile device 310. When judgement is made that the no battery pack that meets the specifications of the vehicle 100 is present in the inventory, the server 380 may cause the display device 390 to display a message explaining the situation, and terminate the battery replacement processing. When a battery pack is selected in S31, the processing transitions to S32.

In S32, the server 380 controls the replacement device 350 such that the battery pack B1 is removed from vehicle body 10. Thus, the vehicle body 10 and the battery pack B1 are separated. The processing then transitions to S33.

Although not shown in the flowchart, reuse processing is executed with respect to the battery pack B1 that is removed. Specifically, the recovery device 330 transports (recovers) the battery pack B1 from the replacement device 350 to the second stockpile device 320. The battery packs stockpiled in the second stockpile device 320 are sequentially inspected by the inspection device, and the sorting device sorts the battery packs by purpose based on the inspection results. Each battery pack is reused for a corresponding purpose (for vehicle use, stationary use, etc.). Battery packs that cannot be reused are discarded. The battery packs (for vehicle use) to be reused in the battery replacement system 300 are transported to the first stockpile device 310 by the loading device 340. The battery packs that are transported are loaded into the first stockpile device 310.

In S33, the server 380 controls the charger of first stockpile device 310 such that the battery pack B2 selected in S31 is charged. Note however, that the charging timing can be changed as appropriate. A battery pack that is charged may be loaded into the first stockpile device 310. When the charging is completed, the server 380 controls the supply device of the first stockpile device 310 to transport (supply) the battery pack B2 from the first stockpile device 310 to the replacement device 350. Next, the server 380 controls the replacement device 350 to attach the battery pack B2 to the vehicle body 10. At this time, the SMR 23 of the battery pack B2 that is attached is in an open state. Thereafter, the server 380 transmits a signal notifying completion of attaching the battery pack (hereinafter referred to as "replacement-completed signal") to the ECU 18a.

FIG. 2 illustrates an example in which removal of the battery packs and attachment of the battery packs are performed at different positions. The vehicle position may be adjusted before removing the battery pack, before attaching the battery pack, or both. A transport device (e.g., a conveyor-kind transport device), or a transport robot, which are omitted from illustration, may move the vehicle. However, removal of the battery packs and attachment of the battery packs may be performed at the same position. The replacement of the battery packs (removal and attachment) may be performed with the vehicle in a stationary state. Any transport method may be used as a transport method in each of the recovery device 330, the supply device, and the loading device 340, as well. These transport methods may be a conveyor method or a method using a transport robot. Note that the user may manually replace the battery packs (power storage devices) without communication between the battery replacement system (station) and the vehicle.

For example, when the battery pack B2 is attached to the vehicle body 10, the terminals T21 and T22 of the battery pack B2 are connected to the terminals T11 and T12 of the vehicle body 10, respectively. Accordingly, the vehicle body 10 and the battery pack B2 are in the connected state illustrated in FIG. 1. By attaching the battery pack B2 to the vehicle body 10, the low-voltage power supply lines (circuits CR12, CR22) and the communication lines (communication lines CL1, CL2) are connected between the vehicle body 10 and the battery pack B2. The processing flow of S21 to S24 shown in FIG. 3 is then started at the battery pack B2.

In S21, the ECU 28a is started by electric power supplied from the power supply (accessory battery 17) within the vehicle body 10. The processing then transitions to S22.

In S22, the ECU 28a transmits information indicating the state of the battery pack (hereinafter referred to as "state information") to the ECU 18a. The state information includes, for example, information regarding the battery pack specifications and information regarding voltage of the current battery 21 that is detected by the BMS 22a. The voltage of the battery 21 may vary depending on the SOC of the battery 21. The processing then transitions to S23.

In S23, the ECU 28a determines whether an SMR on command has been received from the vehicle body 10. The ECU 28a waits for the SMR on command from the vehicle body 10 in S23 with the SMR 23 maintained in an open state. When the ECU 28a receives the SMR on command (YES in S23), the processing then transitions to S24.

In S24, the ECU 28a switches the SMR 23 from an open state (disconnected state) to a closed state (connected state).

On the other hand, when the battery pack B2 is attached to the vehicle body 10, the ECU 18a receives the replacement completion signal from the server 380 (S33). Thus, judgment of YES is made in S12, and the processing advances to S13.

In S13, the ECU 18a determines whether the above state information has been received from the ECU 28a of the battery pack B2. Upon the ECU 18a receiving the above state information from the battery pack B2 (YES in S13), the processing then transitions to S14.

In S14, the ECU 18a executes battery characteristics determination processing. When the battery pack 20 is replaced, the user may experience uncomfortableness, depending on the difference in performance between the battery pack B2 after replacement and the reference battery. For example, when replacing with a battery pack with a lower input/output than the reference battery, the user may feel uncomfortable due to the change in output performance and the increased charging time before and after the replacement. Accordingly, the ECU 18a executes processing to determine whether there is any difference in characteristics between the battery pack B2 and a reference battery, based on battery information acquired from the battery pack B2 after the battery pack B1 that was installed in the vehicle 100 is replaced with the battery pack B2, as battery characteristics determination processing.

Battery characteristics determination processing will be described below with reference to FIG. 4. FIG. 4 is a flowchart showing an example of battery characteristics determination processing in FIG. 3.

In S100, the ECU 18a acquires the amount of time t(1) necessary for charging of a predetermined SOC of the reference battery. The ECU 18a acquires the amount of time t(1) from a storage region in which it was stored in S10. The processing then transitions to S102.

In S102, the ECU 18a acquires the amount of time t(2) necessary for charging of the predetermined SOC from the state information received in S13 from the battery pack B2 after replacement. The processing then transitions to S104. The memory of the ECU 28a of the battery pack B2 after replacement stores in advance information regarding specifications such as, for example, the amount of time t(2) necessary for charging of the predetermined SOC in a new product state (initial state), or the like.

In S104, the ECU 18a determines whether the magnitude in difference between the amount of time t(2) and the amount of time t(1), i.e., | t(2) - t(1) | is no smaller than a threshold value α. When determination is made that the magnitude of the difference between the amount of time t(2) and the amount of time t(1) is no smaller than the threshold value α (YES in S104), the processing transitions to S106.

In S106, the ECU 18a sets a determination flag, indicating that there is a difference in characteristics before and after replacement, to an on state. The processing then transitions to S15. On the other hand, when determination is made that the magnitude of the difference between the amount of time t(2) and the amount of time t(1) is smaller than threshold value α (NO in S104), the processing transitions to S108.

In S108, the ECU 18a sets the determination flag, indicating that there is a difference in characteristics before and after replacement, to an off state. The processing then transitions to S15.

In S15, the ECU 18a determines whether there is a difference in the characteristics of the battery pack before and after replacement. For example, when the determination flag is in the on state, the ECU 18a determines that there is a difference in characteristics before and after replacement. On the other hand, when the determination flag is in the off state, the ECU 18a determines that there is no difference in characteristics before and after replacement. When determination is made that there is a difference in characteristics before and after replacement (YES in S15), the processing transitions to S 16. Note that when determination is made that there is no difference in characteristics before and after replacement (NO in S 15), this processing ends.

In S 16, the ECU 18a executes display processing. The ECU 18a executes, as display processing, processing of displaying, on the display device of the HMI 19a, an image relating to an energy flow indicating that there is a difference in the characteristics of the battery pack 20 before and after replacement, in place of a normal image relating to energy flow.

FIG. 5 is a diagram illustrating an example of normal display of energy flow during regenerative braking. As illustrated in FIG. 5, for example, when the battery pack B2 is installed in the vehicle body 10, an image of the vehicle 100 including wheels 40, the MG 11a, and the battery pack 20 is displayed on the display device of the HMI 19a. The display of these is also displayed while the vehicle 100 is being driven, for example. For example, when regenerative braking is performed in the vehicle 100, an arrow from a wheel 40 serving as a drive wheel to the MG 11a, and an arrow from the MG 11a to the battery pack 20, are displayed, thereby visually presenting a flow of regenerative electric power (energy flow) to the user. At this time, for example, text information regarding the rated voltage of the battery pack 20 is displayed on the image.

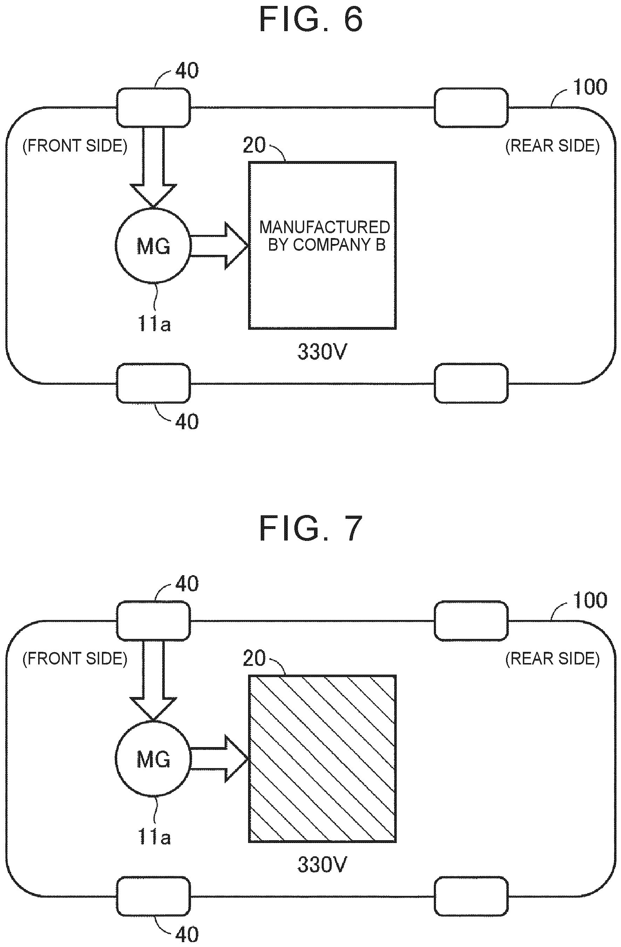

FIG. 6 is a diagram illustrating an example of a display of energy flow during regenerative braking. When it is determined that there is a difference in the characteristics of the battery pack 20 before and after replacement, an image illustrated in FIG. 6 may be displayed instead of the image illustrated in FIG. 5 which corresponds to the normal display. The image used when determination is made that there is a difference in the characteristics of the battery pack 20 before and after replacement may be an image in which the battery pack 20 after replacement is displayed in a different form as compared to the image illustrated in FIG. 5 that corresponds to the normal display. For example, as illustrated in FIG. 6, an image including the rated voltage of the battery pack 20 after replacement, as well as text information of the supplier, may be displayed as an image to be used when determination is made that there is a difference in the characteristics of the battery pack before and after replacement. Alternatively, an image containing text information of the suppliers of the battery packs 20 before and after replacement may be displayed, or an image containing text information indicating that the battery pack has been changed from a battery pack of specifications set in advance to a battery pack of specifications different from the specifications set in advance may be displayed, or an image containing text information indicating that a battery pack of low capacity has been changed to a battery pack of high capacity may be displayed, or an image containing text information indicating that the charging time required to charge by a predetermined SOC has become longer due to the battery pack replacement may be displayed.

FIG. 7 is a diagram illustrating another example of a display of energy flow during regenerative braking. When determination is made that there is a difference in the characteristics of the battery pack 20 before and after replacement, the image illustrated in FIG. 7 may be displayed, instead of the image illustrated in FIG. 5 that corresponds to the normal display. As an image to be used when determination is made that there is a difference in the characteristics of battery pack 20 before and after replacement, an image including text information indicating that, with respect to the rated voltage of the battery pack before and after replacement, a high-voltage battery pack has been replaced with a low-voltage battery pack, may be displayed, and color of a portion in a hatched region in FIG. 7 may be changed.

Note that after the battery pack 20 is attached to the vehicle body 10, various states of the battery pack 20 that is attached, such as the voltage and so forth, may be detected to determine whether there is an abnormality in the battery pack after replacement.

Thus, in the vehicle 100 according to the present embodiment, when the battery pack B1 is replaced with the battery pack B2, and there is a difference in characteristics between battery pack B2 and the reference battery of specifications set in advance, the user is notified that there is a difference in characteristics, and is thus able to recognize that there is a difference in the characteristics of the battery pack before and after the replacement. Accordingly, imparting uncomfortable sensations to the user due to difference in performance before and after replacement of the battery pack 20 can be suppressed. Thus, a vehicle can be provided that suppresses uncomfortable sensations of the user before and after battery replacement. In other words, the vehicle acquires a new function of monitoring the characteristics of the battery pack 20 before and after replacement and providing an alert if there is a difference in the characteristics.

Further, after the battery pack B2 after replacement is connected to the vehicle body 10 as a power supply, when the magnitude of the difference in characteristics | t(2) - t(1) |, which is indicated by the amount of time required to perform charging thereof by a predetermined SOC, is no less than the threshold value α, the fact that there is a difference in characteristics is displayed using the display device of the HMI 19a, whereby uncomfortable sensations of the user due to the difference in performance before and after the battery pack replacement can be suppressed.

A modification will be described below.
In the above embodiment, a case in which one battery pack 20 is installed in the vehicle 100 has been described as an example, but the vehicle 100 may be configured such that two or more battery packs 20 are installed.

Furthermore, in the above-described embodiment, description has been made that the time required to charge the SOC by a predetermined SOC is defined as characteristics of the battery pack 20 set in advance, and battery characteristics determination processing is executed to determine the difference in characteristics between the battery pack after replacement and a reference battery, but the characteristics of the battery pack are not limited to time such as described above. The characteristics of the battery pack may be, for example, the voltage of the battery pack 20 at a SOC that is set in advance. The ECU 18a may determine that there is difference in characteristics between the battery pack after replacement and the reference battery when the magnitude of the difference in voltage of the battery packs 20 at the same SOC is no less than a threshold value, for example.

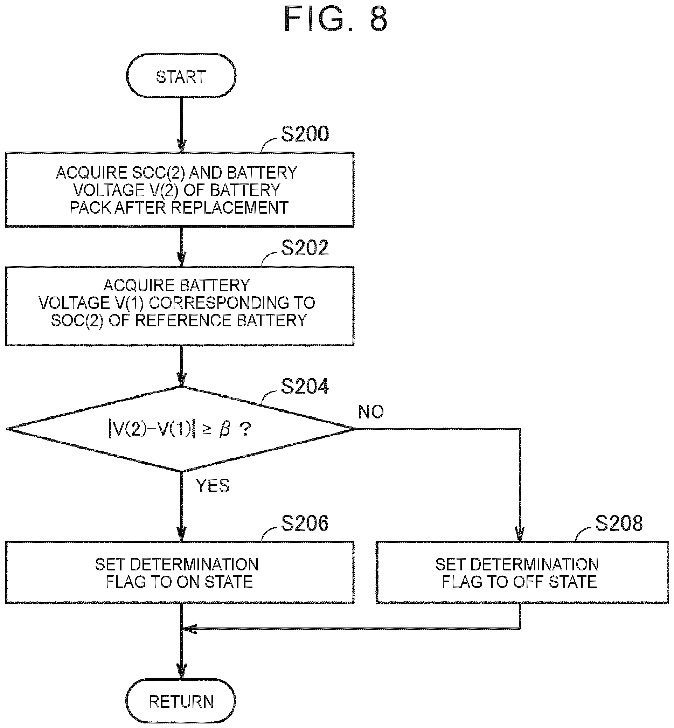

FIG. 8 is a flowchart showing an example of battery characteristics determination processing in a modification. The processing shown in the flowchart of FIG. 8 is executed, for example, as the battery characteristics determination processing of S14 in the flowchart of FIG. 3.

In S200, the ECU 18a acquires SOC(2) and battery voltage V(2) of the battery pack B2 after replacement. The ECU 18a acquires, for example, the SOC(2) and the battery voltage V(2) of the battery pack B2 after replacement, contained in the state information received from the ECU 28a. The processing then transitions to S202.

In S202, the ECU 18a acquires battery voltage V(1) corresponding to the SOC(2) of the reference battery. The ECU 18a reads out the battery voltage V(1) corresponding to the SOC(2) of the reference battery from the battery information stored in the memory. The processing then transitions to S204.

In S204, the ECU 18a determines whether the magnitude of difference of the battery voltages |V(2) - V(1)| is no less than a threshold value β. When determination is made that the magnitude of difference of the battery voltages is no less than the threshold value β (YES in S204), the processing transitions to S206.

In step S206, the ECU 18a sets the determination flag to an on state. The processing then transitions to S15. Note that when determination is made that the magnitude of difference of the battery voltages is smaller than threshold value β (NO in S204), the processing transitions to S208.

In step S208, the ECU 18a sets the determination flag to an off state. The processing then transitions to S15.

In this way, when the magnitude of difference between battery voltage V(1) and battery voltage V(2) is no less than threshold value β, the user is notified that there is a difference in characteristics, and is thus able to recognize that there is a difference in characteristics before and after replacement. Accordingly, imparting uncomfortable sensations to the user due to difference in performance before and after replacement of the battery can be suppressed.

Further, in the above-described embodiment, description is made that the time required to charge the SOC by a predetermined SOC is defined as a characteristic that is set in advance, with battery characteristics determination processing being executed to determine the difference in characteristics of the battery pack 20 before and after replacement, but the characteristics set in advance are not limited to time, such as described above. The characteristics set in advance may be, for example, the supplier of the battery pack 20. For example, the ECU 18a may determine that there is a difference in the characteristics of the battery pack 20 when the supplier of the battery pack 20 after replacement is different from the supplier of the reference battery.

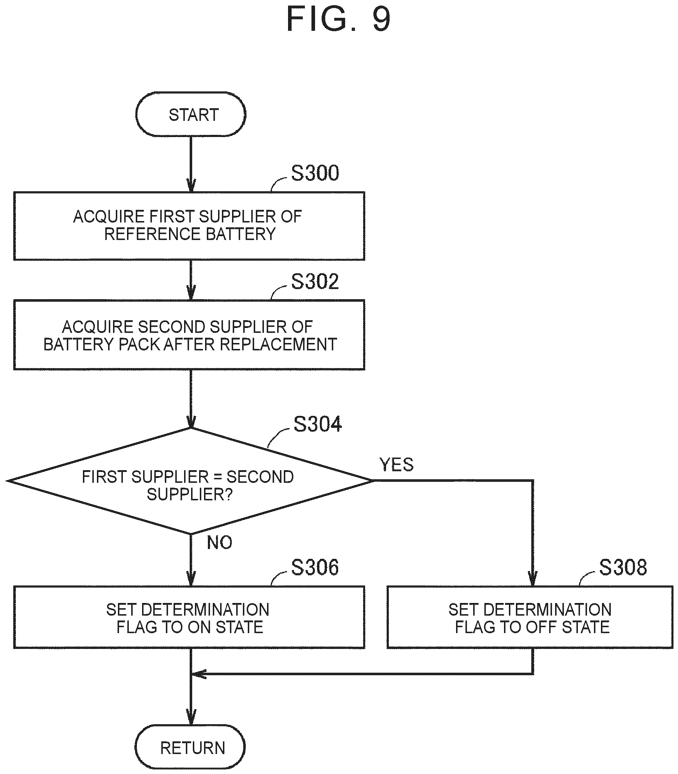

FIG. 9 is a flowchart showing another example of battery characteristics determination processing in a modification. The processing shown in the flowchart in FIG. 9 is executed, for example, as the battery characteristics determination processing of S14 in the flowchart of FIG. 3.

In S300, the ECU 18a acquires the supplier of the reference battery (hereinafter referred to as "first supplier") from the memory. The processing then transitions to S302.

In S302, the ECU 18a acquires the supplier of the battery pack B2 after replacement (hereinafter, referred to as "second supplier"). The ECU 18a acquires, for example, information regarding the supplier of the battery pack B2 after replacement from the state information received from the ECU 28a. The processing then transitions to S304.

In S304, the ECU 18a determines whether the first supplier and the second supplier are different. When determination is made that the first supplier and the second supplier are different (NO in S304), the processing transitions to S306.

In step S306, the ECU 18a sets the determination flag to an on state. The processing then transitions to S15. Note that when determination is made that the first supplier and the second supplier are the same (YES in S304), the processing transitions to S308.

In step S308, the ECU 18a sets the determination flag to an off state. The processing then transitions to S15.

In this way, when the first supplier and the second supplier are different, the user is notified of the difference in characteristics, and thus is able to recognize that there is a difference in characteristics before and after the replacement. Accordingly, imparting uncomfortable sensations to the user due to difference in performance before and after replacement of the battery pack 20 can be suppressed.

Further, in the above-described embodiment, description is made that the time required to charge the SOC by a predetermined SOC is defined as a characteristic that is set in advance, with battery characteristics determination processing being executed to determine the difference in characteristics of the battery pack 20 before and after replacement, but the characteristics set in advance are not limited to time, such as described above. The characteristics set in advance may be, for example, the installation position of the battery pack 20, and the reference battery may include the battery pack B1. For example, when multiple battery packs can be installed in the vehicle 100, a plurality of installation positions are set. When the vehicle 100 is equipped with fewer battery packs than an upper limit number, the installation positions after replacement may differ from the installation positions before replacement.

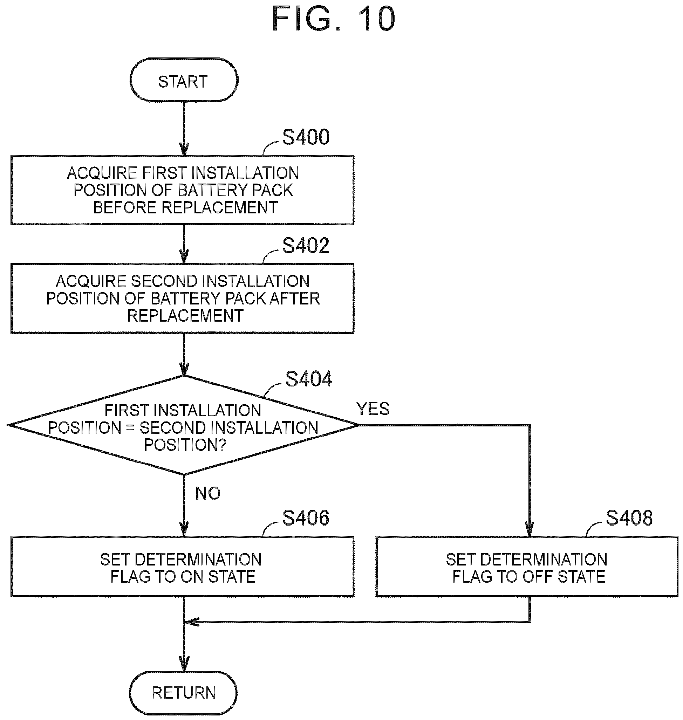

FIG. 10 is a flowchart showing yet another example of battery characteristics determination processing according to a modification. The processing shown in the flowchart in FIG. 10 is executed, for example, as the battery characteristics determination processing of S14 in the flowchart of FIG. 3.

In S400, the ECU 18a acquires the installation position of the battery pack B1 before replacement (hereinafter referred to as "first installation position") from the memory. The memory of the ECU 18a stores information regarding the installation position of the battery pack B1 before replacement. The processing then transitions to S402.

In S402, the ECU 18a acquires the installation position of the battery pack B2 after replacement (hereinafter referred to as "second installation position"). The ECU 18a acquires information regarding the installation position of the battery pack B2 after replacement, received from the server 380 or the like, for example. The processing then transitions to S404.

In S404, the ECU 18a determines whether the first installation position and the second installation position are different. When determination is made that the first installation position and the second installation position are different (NO in S404), the processing transitions to S406.

In step S406, the ECU 18a sets the determination flag to an on state. The processing then transitions to S15. Note that when determination is made that the first installation position and the second installation position are the same mounting position (YES in S404), the processing transitions to S408.

In step S408, the ECU 18a sets the determination flag to an off state. The processing then transitions to S15.

In this way, when the installation positions of the battery pack 20 before and after replacement are different, the user is notified of the difference in characteristics, and thus is able to recognize that there is a difference in characteristics before and after replacement. Accordingly, imparting uncomfortable sensations to the user due to difference in performance before and after replacement of the battery pack 20 can be suppressed.

Furthermore, in the above embodiment, description is made that an image indicating that there is a difference in the characteristics of the battery packs 20 is displayed on the display device of the HMI 19a, but an arrangement may be made in which the above image is displayed on a display device of the user terminal. The user terminal may be, for example, a mobile terminal carried by the user of the vehicle 100. Examples of mobile terminals include smartphones, laptops, handheld game consoles, wearable devices, and electronic keys.

Furthermore, in the above-described embodiment, the vehicle 100 is a passenger car as an example; but the vehicle 100 is not limited to being a passenger car, and may be, for example, a bus, a truck, or a work vehicle (e.g., a tractor, a combine harvester, or a forklift). The vehicle 100 may be further configured to be capable of travelling unmanned by automated driving or remote driving.

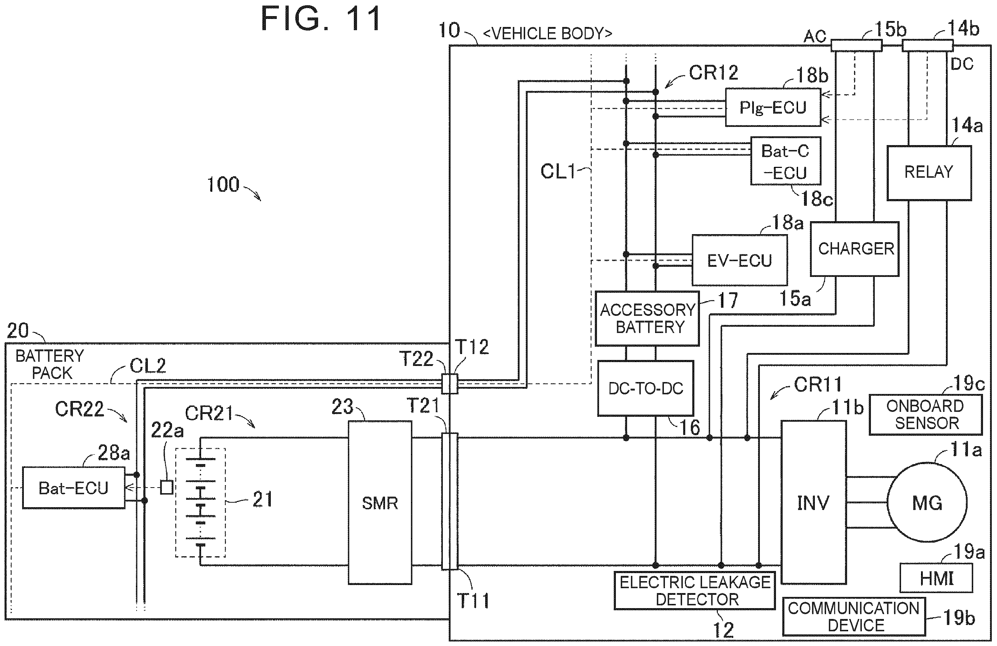

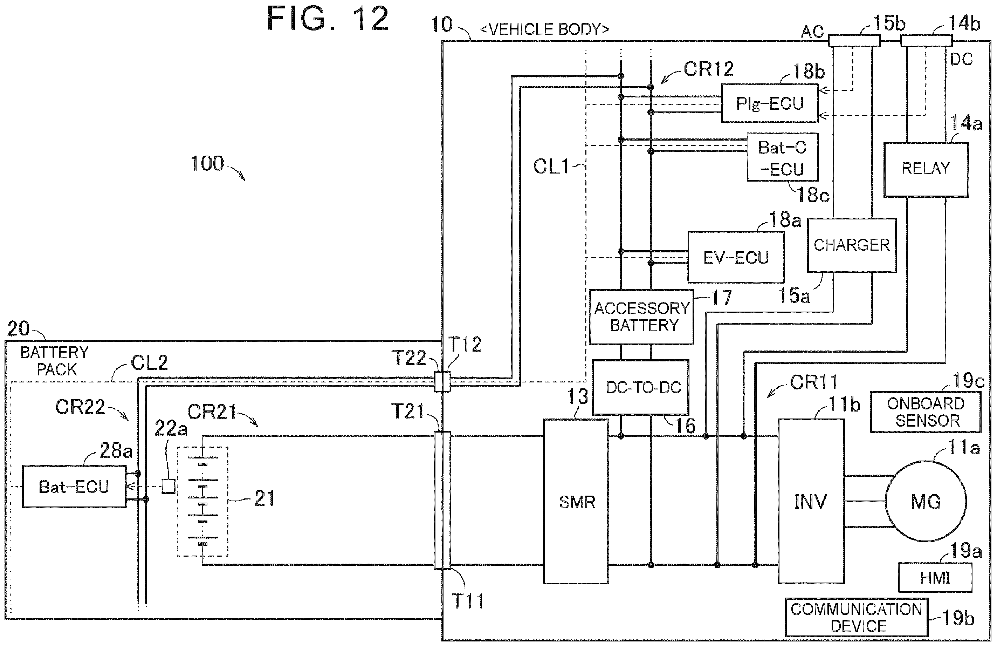

The configurations of the vehicle body illustrated in FIG. 1 can be further changed as appropriate. For example, the SMR 13 of the vehicle body 10 may be omitted as illustrated in FIG. 11, or the SMR 23 of the battery pack 20 may be omitted as illustrated in FIG. 12. Also, at least one of the DC inlet 14b or the AC inlet 15b may be omitted, or may be changed to one inlet common to AC and DC. These inlets may be configured to enable bidirectional electric power transfer. The vehicle body may execute external power feed (Vehicle to Everything (V2X)) using electric power output from a battery pack that is attached.

Note that all or part of the above modifications may be carried out combined as appropriate.
The embodiment disclosed herein should be construed as exemplary in all respects and not restrictive. The scope of the invention is set forth in the claims rather than in the above description, and is intended to include all modifications within the meaning and scope equivalent to those of the claims.

## Claims

1. A vehicle (100) comprising:
a notification device that performs notification of vehicle information regarding the vehicle (100); and
a control device that controls the notification device, wherein the control device is configured to
acquire battery information from a battery (21) installed as a power supply in the vehicle (100),
perform, after a first battery installed in the vehicle (100) is replaced with a second battery, when a difference in characteristics is found between the second battery, and a reference battery of specifications set in advance, based on the battery information acquired from the second battery, notification of information indicating that there is the difference in the characteristics before and after replacement, using the notification device.

2. The vehicle (100) according to claim 1, wherein after the second battery being connected to the vehicle (100) as the power supply, when a magnitude in difference between a value indicating a characteristic of the reference battery that is set in advance and a value indicating the characteristic of the second battery that is set in advance is greater than a threshold value, the control device performs notification of information indicating that there is the difference in the characteristics, using the notification device.

3. The vehicle (100) according to claim 2, wherein:
the notification device is a display device; and
when the vehicle (100) is started for a first time after the battery being replaced with the second battery, and the magnitude of the difference is greater than the threshold value, the control device uses the notification device to cause the display device to display an image including information indicating that there is the difference in the characteristics.

4. The vehicle (100) according to claim 1, wherein when a magnitude in difference between a first amount of time necessary to change a state of charge of the reference battery by a value set in advance and a second amount of time necessary to change the state of charge of the second battery by the value set in advance is greater than a threshold value, the control device performs notification of information indicating that there is the difference in the characteristics, using the notification device.

5. The vehicle (100) according to claim 1, wherein when a magnitude in difference between a first voltage of the reference battery and a second voltage of the second battery is greater than a threshold value, in a state in which the reference battery and the second battery are at a same state of charge, the control device performs notification of information indicating that there is the difference in the characteristics, using the notification device.

6. The vehicle (100) according to claim 1, wherein when a supplier of the reference battery and a supplier of the second battery are different, the control device performs notification of information indicating that there is the difference in the characteristics, using the notification device.

7. The vehicle (100) according to claim 1, wherein the specifications set in advance include specifications of the first battery.

8. The vehicle (100) according to claim 1, wherein:
the reference battery includes the first battery before replacement; and
when an installation position of the first battery and an installation position of the second battery differ, the control device performs notification of information indicating that there is the difference in the characteristics, using the notification device.

9. A method for determining characteristics of a battery to be installed in a vehicle (100) as a power supply, the method comprising:
acquiring battery information from a second battery after a first battery is replaced with the second battery; and
when a difference in characteristics is found between the second battery and a reference battery of specifications set in advance based on the battery information of the second battery, providing notification of information indicating that there is the difference in the characteristics before and after replacement.

10. The method according to claim 9, wherein after the second battery is connected to the vehicle (100) as the power supply, when a magnitude in difference between a value indicating a characteristic of the reference battery set in advance and a value indicating the characteristic of the second battery set in advance is greater than a threshold value, providing the notification of information indicating that there is the difference in the characteristics.
